(19) Europäisches Patentamt
European Patent Office
Office européen des brevets

(11) **EP 1 433 232 B1**

(12) **FASCICULE DE BREVET EUROPEEN**

(45) Date de publication et mention
de la délivrance du brevet:
**06.01.2010 Bulletin 2010/01**

(51) Int Cl.:
***H01S 5/14*** *(2006.01)*

(21) Numéro de dépôt: **02772510.0**

(86) Numéro de dépôt international:
**PCT/FR2002/002915**

(22) Date de dépôt: **21.08.2002**

(87) Numéro de publication internationale:
**WO 2003/019737 (06.03.2003 Gazette 2003/10)**

(54) **SOURCE LASER EN OPTIQUE GUIDEE**

WELLENLEITERLASERQUELLE

LASER SOURCE IN GUIDED OPTICS

(84) Etats contractants désignés:
**AT BE BG CH CY CZ DE DK EE ES FI FR GB GR IE IT LI LU MC NL PT SE SK TR**

(30) Priorité: **23.08.2001 FR 0111043**

(43) Date de publication de la demande:
**30.06.2004 Bulletin 2004/27**

(73) Titulaire: **Teem Photonics
38240 Meylan (FR)**

(72) Inventeurs:
• **DELLEA, Olivier
F-38240 Meylan (FR)**
• **MOLVA, Engin
F-38000 Grenoble (FR)**

(74) Mandataire: **Poulin, Gérard et al
Brevalex
3, rue du Docteur Lancereaux
75008 Paris (FR)**

(56) Documents cités:
**US-A- 4 677 630     US-A- 5 513 196**

• **MODH P ET AL: "Deep-etched distributed Bragg reflector lasers with curved mirrors. Experiments and modeling" IEEE JOURNAL OF QUANTUM ELECTRONICS, JUNE 2001, IEEE, USA, vol. 37, no. 6, pages 752-761, XP002204379 ISSN: 0018-9197**
• **PATENT ABSTRACTS OF JAPAN vol. 013, no. 558 (E-858), 12 décembre 1989 (1989-12-12) & JP 01 231387 A (FUJITSU LTD), 14 septembre 1989 (1989-09-14)**

**Description**

**Domaine technique**

La présente invention concerne une source laser en optique guidée, cette source laser étant apte à émettre une onde lumineuse présentant de un à quelques modes et pouvant présenter une forte puissance.

L'invention trouve des applications dans tous les domaines nécessitant une source laser à peu de modes et notamment dans le domaine des télécommunications optiques, par exemple comme source de pompe des amplificateurs optiques ou encore dans des domaines tels que la médecine, la spectroscopie, ou la métrologie utilisant des sources lasers monomodes ou faiblement multimodes.

**Etat de la technique antérieure**

Aujourd'hui, pour régénérer un faisceau se propageant dans une fibre optique, les systèmes développés dans le cadre des télécommunications optiques mettent en oeuvre des amplificateurs optiques. Les guides d'ondes optiques utilisés actuellement dans les amplificateurs optiques sont généralement monomodes ou faiblement multimodes. De ce fait, les amplificateurs sont généralement pompés par des diodes lasers de pompe qui, pour être compatibles avec un couplage à ces guides optiques, sont monomodes ou faiblement multimodes.

Dans l'état actuel de la technique, les diodes lasers à un ou peu de modes présentent des puissances faibles et sont de coût élevé alors que les diodes lasers, à forte puissance (notamment les diodes lasers de pompe à ruban large), sont multimodes et donc incompatibles avec un couplage à des guides optiques.

D'une façon plus générale, les sources laser connues qui présentent une puissance élevée sont le plus souvent multimodes, ce qui pose des problèmes d'adaptation de modes et donc de couplage avec les guides optiques destinés à la propagation et/ou à la transformation de l'onde lumineuse issue de ces sources ; et les sources lasers qui présentent un ou peu de modes sont de faible puissance.

On entend par guide optique, aussi bien un guide planaire, un microguide ou encore une fibre optique.

Un microguide est un guide à confinement latéral, par opposition à guide planaire dans lequel la lumière peut se propager dans un plan : le plan du guide.

Le document US-A-5 513 196 divulgue une source laser conforme au préambule de la revendication 1.

Le document Patent Abstracts of Japan, Vol. 013, N°558 (E-858), 12 décembre 1989 (correspondant à JP-A-01 231 387) divulgue un dispositif émetteur de lumière fournissant une onde monomode en faisant osciller la lumière de sortie d'une diode laser monomode au moyen de deux résonateurs et en utilisant une lentille comme miroir d'un résonateur externe.

Le brevet US-A-4 677 630 divulgue un laser à semiconducteur monomode présentant une cavité résonnante disposée à l'extérieur du laser.

Le document « Deep-etched distributed Bragg reflector lasers with curved mirrors. Experiments and modeling", P. Modh et al., IEEE Journal of Quantum Electronics, Vol. 37, N° 6? Juin 2001, divulgue un laser comportant des miroirs concaves dans un plan de guidage, les miroirs étant réalisés par simple gravure.

**Exposé de l'invention**

La présente invention a pour but de proposer une source laser en optique guidée ne présentant pas les limitations et difficultés des sources mentionnées ci-dessus.

Un but de invention est en particulier de proposer une source laser présentant une très bonne qualité optique de faisceau. On entend par une bonne qualité optique de faisceau, un faisceau comportant un ou peu de modes, c'est-à-dire un faisceau proche de la limite de diffraction.

Un autre but est encore de proposer une source laser pouvant présenter sans que cela soit limitatif, une forte puissance.

Un but de l'invention est encore de proposer une source laser à faible coût et de réalisation aisée.

Pour atteindre ces buts, l'invention propose une source laser en optique guidée à cavité laser étendue, comportant :

- une cavité laser apte à émettre un faisceau optique,
- un élément d'optique guidée présentant :

    • une zone de guidage d'entrée,

    • une zone de sortie comprenant au moins un microguide et

- une zone de guidage planaire d'adaptation entre la zone d'entrée et le microguide, la zone de guidage d'entrée étant apte à recevoir le faisceau optique émis par la cavité et le transmettre à la zone de guidage d'adaptation, cette dernière étant apte à le guider vers le microguide qui est associé à au moins une sortie optique de la source, caractérisée en ce que la zone de guidage d'entrée comporte un miroir concave au moins dans un plan de guidage de la zone d'entrée, de façon à réaliser avec la cavité laser une cavité laser étendue.

La source laser de l'invention permet d'avoir un faisceau en sortie du microguide qui présente seulement un à quelques modes, même si la cavité laser émet un faisceau multimodes ; de plus les pertes de puissance du faisceau dans l'élément d'optique guidée, sont faibles ce qui permet, si la cavité laser émet un faisceau optique de forte puissance, d'avoir une source laser de forte puissance.

Ainsi, l'élément d'optique guidée de la source de l'invention est apte à réduire le nombre de modes d'une onde lumineuse pour qu'il soit compatible notamment avec des composants d'optique guidée monomode ou faiblement multimodes ; de ce fait la cavité laser de l'invention peut être choisie pour ses caractéristiques de puissances, sans contraintes sur le nombre de modes de l'onde émise.

Selon l'invention, on entend par guidage planaire, un guidage optique selon un plan de guidage ; le plan de guidage peut prendre des orientations différentes selon la position du guide dans l'élément et le type de guide. En particulier, le guide planaire peut être à des profondeurs variables dans l'élément. Il en est de même des microguides qui peuvent être plus ou moins enterrés.

Selon un mode préféré, la cavité laser est une diode laser comportant au moins un miroir plan.

Tous les types de diodes lasers peuvent être utilisées et par exemple les diodes lasers à ruban large, les diodes lasers multi-rubans, les diodes lasers à réseau de Bragg, les diodes lasers à émission verticale (connues sous le nom de VCSEL pour Vertical Cavity Surface Emitting Laser), etc...

La cavité laser peut être disposée directement sur l'élément d'optique guidée, au niveau de la zone de guidage d'entrée de cet élément, par toutes les techniques d'assemblage classiques et par exemple par l'utilisation d'un support apte à maintenir la cavité et l'élément optique.

La cavité laser peut également être disposée en regard de la zone de guidage d'entrée de sorte qu'il existe une zone d'espace libre entre la cavité et la zone de guidage d'entrée.

L'élément d'optique guidée est réalisé avantageusement en optique intégrée à partir d'un substrat monocouche ou multicouche dans lequel sont formées la zone d'entrée, la zone d'adaptation et la zone de sortie. Selon un mode préféré, le substrat est un substrat en verre et les guides et microguides de cet élément sont réalisés par les techniques d'échanges d'ions dans le verre ou par dépôt de couches.

La zone de guidage d'entrée comporte un guide planaire relié à la zone de guidage d'adaptation par le miroir concave qui est réalisé avantageusement par une variation locale d'indice effectif dudit guide planaire. La longueur $L_1$ de cette zone, suivant la direction de propagation du faisceau, dépend de la longueur optique L de la source. Cette longueur optique dépend du milieu traversé par le faisceau optique jusqu'au miroir et est composé du milieu de la cavité qui correspond pour l'essentiel à celui du matériau laser, éventuellement d'un milieu en espace libre et du milieu formé par le guide de la zone d'entrée. Ainsi, dans certains cas, le miroir concave peut être disposé directement en entrée de l'élément optique, ce qui réduit la longueur de la zone d'entrée à la flèche h du miroir concave.

Le miroir de l'élément optique est concave au moins dans un plan de guidage. Il est réalisé avantageusement par une variation locale d'indice effectif du guide de la zone d'entrée. Cette variation d'indice peut être obtenue notamment par une cavité localisée dans le substrat au-dessus du guide planaire, par un dépôt local d'au moins une couche sur le substrat au-dessus du guide planaire, par un enterrage local du guide planaire, par un échange d'ions localisé dans le substrat au-dessus du guide planaire ou encore par un réseau de Bragg dans le substrat au-dessus du guide planaire. Bien entendu, cette liste n'est pas exhaustive et d'autres modes de réalisation du miroir concave peuvent être utilisés pour réaliser l'élément optique de l'invention.

Selon un mode de réalisation particulier, le miroir concave de l'invention est en outre apte à filtrer une ou plusieurs longueurs d'onde du faisceau émis par la cavité laser en réfléchissant de façon sélective lesdites longueurs d'onde. On utilisera avantageusement pour ce cas particulier un miroir formé par un réseau de Bragg.

Pour que la source laser de l'invention soit optiquement stable, c'est-à-dire qu'elle établisse au moins un mode optique stable, le rayon de courbure R du miroir concave doit être supérieur ou égal à la longueur optique L de la source définie par la relation $L = n_c.L_c + n_e.D + n_1.L_1$ où $n_1$ est l'indice effectif de la zone de guidage d'entrée et $n_c$, $n_e$, sont les indices de réfraction respectivement du matériau de la cavité laser et du milieu de la zone d'espace libre intercalé entre la cavité et l'élément d'optique guidé et $L_c$, D, $L_1$, sont respectivement les longueurs de la cavité, de la zone d'espace libre située entre la cavité et l'élément d'optique guidé, et de la zone d'entrée.

Lorsque la cavité est disposée directement sur l'élément d'optique guidé, alors D=0 et $L = n_c.L_c + n_1.L_1$.

Ainsi, le miroir concave présente comme on l'a vu un rayon de courbure R et est disposé à une distance de la cavité laser telle qu'il forme avec la zone d'entrée, le milieu intercalé entre ladite cavité et l'élément d'optique guidée et la cavité laser, une cavité laser étendue, le miroir concave permettant de transmettre une partie du faisceau laser établi dans la cavité étendue. La réflectivité du miroir concave est partielle (quelques % à quelques dizaines de %).

Les caractéristiques géométriques du miroir concave, doivent obéir aux égalités et inégalités suivantes :

$$W_o{}^2 = \frac{\lambda}{\pi}[L.(R-L)]^{\frac{1}{2}} \quad et \quad 2w_0 > l_r$$

$$w^2 = \frac{\lambda R}{\pi}[L/(R-L)]^{\frac{1}{2}}$$

$$R > L$$

$$L = n_c.L_c + n_e.D + n_1.L_1$$

$$H/R = 1-(1-d^2/4R^2)^{\frac{1}{2}}.$$

$$d > 2w$$

où $\lambda$ est la longueur d'onde considérée du faisceau lumineux, $w_0$ est le rayon dudit faisceau sur le miroir plan de la cavité, $l_r$ est la largeur du ruban de la cavité laser, R le rayon de courbure du miroir concave, L la longueur optique de la source, w le rayon du faisceau lumineux sur le miroir concave, h la flèche dudit miroir concave dans le plan de guidage et d le diamètre de ce miroir.

Selon un mode avantageux, des moyens de focalisation tels que par exemple des moyens de collimation sont intercalés entre la cavité laser et l'élément d'optique guidée pour optimiser le couplage entre la cavité laser et l'entrée de l'élément au moins dans un plan perpendiculaire au plan de guidage de la zone d'entrée et perpendiculaire à la direction de propagation du faisceau lumineux.

La zone de guidage d'adaptation comprend avantageusement un guide planaire en forme d'entonnoir appelé Taper en terminologie anglo-saxonne au moins dans le plan de guidage du guide. Cette zone d'adaptation permet de concentrer la puissance lumineuse du faisceau optique dans le microguide de la zone de sortie.

De préférence, la zone de guidage d'adaptation est adiabatique afin de permettre une transition lente entre le guide planaire et le microguide et de perdre ainsi le moins possible de la puissance lumineuse.

Selon un mode avantageux, la source laser de l'invention comporte en outre au moins un diviseur à une entrée et à n sorties, dans la zone de sortie de l'élément, ledit diviseur étant relié en entrée, au microguide de sorte que les n sorties du diviseur forment n sorties de la source.

Selon une variante, la source laser selon l'invention comporte en outre x coupleurs (avec x entier supérieur ou égal à 1) dans la zone de sortie de l'élément, chaque coupleur étant associé au microguide, de sorte que respectivement le microguide et chacun des coupleurs forment une sortie de la source.

L'invention permet ainsi de réaliser une source laser à plusieurs sorties émissives, le faisceau lumineux émis à chacune de ces sorties étant monomode ou peu multimode.

D'autres caractéristiques et avantages de l'invention ressortiront mieux de la description qui va suivre, en référence aux figures des dessins annexés. Cette description est donnée à titre purement illustratif et non limitatif.

**Brève description des figures**

- La figure 1 représente schématiquement en coupe un premier mode de réalisation de la source de l'invention,
- La figure 2 est une coupe d'une variante du premier mode de réalisation présentant des moyens de focalisation,
- La figure 3 représente schématiquement en coupe un deuxième mode de réalisation de la source de l'invention,

- La figure 4 représente schématiquement en coupe une source laser selon l'invention à plusieurs sorties optiques,
- La figure 5 représente schématiquement en coupe une autre source laser selon l'invention à plusieurs sorties optiques, et
- Les figures 6a à 6e illustrent en coupe des exemples de miroirs concaves utilisables dans l'invention.

## Description détaillée de modes de mise en oeuvre de l'invention

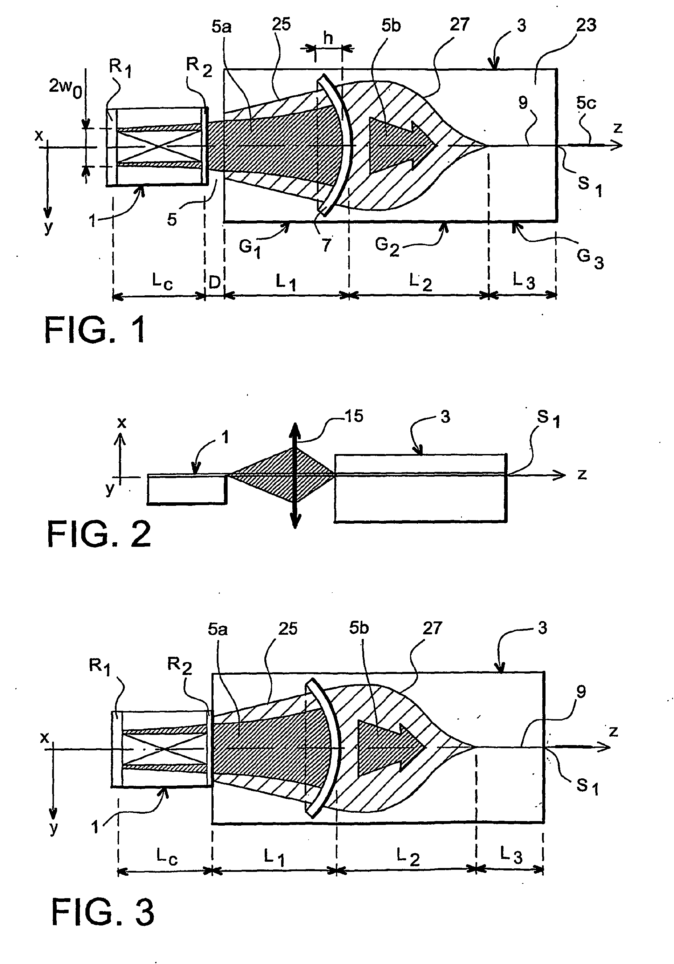

La figure 1 illustre en coupe un premier mode de réalisation de la source de l'invention. Cette coupe est réalisée selon un plan yz de guidage.

Cette source comporte essentiellement une cavité laser 1, apte à émettre un faisceau optique 5, et un élément d'optique guidée 3.

La cavité laser est par exemple une diode laser monoruban permettant par exemple d'avoir un faisceau optique 5 de forte puissance. A titre d'exemple, on peut prendre une diode laser à ruban large de 100 $\mu$m multimodes transverses, émettant une puissance optique de 1 à 2 W. Cette cavité laser comprend deux miroirs $R_1$ et $R_2$ ; de préférence le miroir $R_1$ est très réfléchissant, par exemple de l'ordre de 80% et le miroir $R_2$ est non réfléchissant ou faiblement réfléchissant, par exemple de l'ordre de quelques % voire même inférieur.

L'élément d'optique guidée 3 se compose pour l'essentiel de trois parties :

- une zone $G_1$ de guidage d'entrée comportant un miroir concave 7, la concavité du miroir est définie au moins dans le plan de guidage yz de la zone d'entrée,
- une zone de sortie $G_3$ comprenant au moins un microguide 9 et
- une zone $G_2$ de guidage planaire d'adaptation entre la zone d'entrée $G_1$ et le microguide 9, la zone de guidage d'entrée étant apte à recevoir le faisceau optique 5 émis par la cavité et à le transmettre, via le miroir concave, à la zone de guidage d'adaptation, cette dernière étant apte à le guider vers le microguide 9 qui est associé à au moins une sortie optique $S_1$ de la source.

Cet élément d'optique guidée est réalisé avantageusement en optique intégrée à partir d'un substrat 23 monocouche ou multicouche dans lequel sont formées la zone d'entrée, la zone d'adaptation et la zone de sortie. A titre d'exemple préféré, le substrat est un substrat en verre et les guides et microguides de cet élément sont réalisés par les techniques d'échanges d'ions dans le verre.

Sur cette figure ainsi que sur les suivantes le plan de guidage est le même pour les différentes parties de la source, étant bien entendu que lorsque les guides sont plus ou moins enterrés, le plan de guidage des différentes parties, voire même le plan de guidage dans chaque partie, peut être dans des plans distincts.

Dans un souci de simplification sur ces figures, on n'a représenté que le coeur des guides.

Dans ce mode de réalisation, la zone d'entrée $G_1$ comprend un guide planaire, référencé 25. Ce guide s'étend sur l'ensemble de la longueur $L_1$ de la zone $G_1$, et s'élargit suivant l'axe y avantageusement de l'entrée du guide à son extrémité qui est associé au miroir concave 7.

La forme divergente du guide planaire permet au faisceau lumineux 5a issu de la cavité laser, de se propager librement dans la zone $G_1$ et d'obtenir une cavité laser étendue stable.

Bien entendu, le guide planaire peut avoir une toute autre forme du moment que ses dimensions suivant l'axe y sont supérieures aux dimensions suivant le même axe du faisceau optique guidé 5a, dans $G_1$.

Dans la zone $G_1$, le faisceau optique présente un ou quelques modes élargis dans le plan yz.

La concavité du miroir est définie dans le plan yz. L'axe de symétrie du miroir, 1 dans ce plan correspond à l'axe z qui est la direction de propagation du faisceau lumineux.

Ce miroir concave permet de réaliser une cavité laser étendue. Il transmet le faisceau lumineux 5a issu de la cavité laser 1 et guidé par le guide planaire 25 de la zone d'entrée. Ce miroir est partiellement réfléchissant. Sa réflectivité est par exemple de quelques % à quelques dizaines de %.

Le miroir peut être utilisé également comme un filtre, par exemple de longueurs d'onde, de façon que le miroir 7 ne transmette à la zone $G_2$ qu'un faisceau lumineux 5b avec une ou plusieurs longueurs d'onde sélectionnées.

Ce miroir est réalisé avantageusement par une variation locale d'indice effectif du guide planaire 25.

La zone de guidage d'adaptation $G_2$ qui est relié optiquement au guide planaire 25 par le miroir concave, a pour but de focaliser le faisceau optique spatialement élargi dans le microguide 9.

Cette zone $G_2$ d'adaptation est réalisée par un guide planaire 27 dont la largeur selon l'axe y diminue de la zone $G_1$ à la zone $G_3$, jusqu'à avoir la même largeur que celle du microguide 9 auquel il est relié optiquement.

De préférence la convergence du guide planaire 27, de $G_1$ au microguide 9 est réalisée de façon adiabatique pour minimiser les pertes optiques dans le guide.

Cette convergence en forme d'entonnoir du guide planaire 27 (appelé Taper en terminologie anglo-saxonne) est au moins dans le plan de guidage yz du guide. La longueur de cette zone $G_2$ est $L_2$. Elle est déterminée de façon à permettre de concentrer la puissance lumineuse du faisceau lumineux transmis par le miroir, dans le microguide 9.

Enfin, la dernière zone $G_3$ présente une longueur $L_3$ et comporte au moins un microguide 9 qui permet d'amener le faisceau lumineux issu de la zone d'adaptation, à une sortie $S_1$ de l'élément d'optique guidée.

La sortie $S_1$ peut-être, comme représenté sur cette figure, sur une face du substrat . 23, perpendiculaire à l'axe z, mais elle pourrait être également sur une autre face de ce substrat.

Entre la cavité 1 et l'élément 3, dans l'exemple de la figure 1, le faisceau lumineux 5 se propage sur une distance D dans une zone d'espace libre. Le milieu traversé par le faisceau optique est donc composé du milieu de la cavité 1 qui correspond pour l'essentiel à celui du matériau laser, du milieu de la zone en espace libre (généralement de l'air) et du milieu formé par le guide planaire 25 de la zone d'entrée.

Comme on l'a vu précédemment, pour que la source laser de l'invention soit optiquement stable, c'est-à-dire qu'elle établisse au moins un mode optique stable, le rayon de courbure R du miroir concave doit être supérieur à la longueur optique L de la source définie par la relation $L = n_c.L_c + n_e.D + n_1.L_1$ où $n_c$, $n_e$ sont les indices de réfraction respectivement du matériau de la cavité laser et du milieu de la zone d'espace libre intercalé entre la cavité et l'élément d'optique guidé et $n_1$ est l'indice effectif du guide planaire 25, et $L_c$, D, $L_1$ sont respectivement les longueurs de la cavité 1, de la zone d'espace libre située entre la cavité et l'élément d'optique guidé, et de la zone $G_1$ d'entrée.

La longueur Le est donnée par le fabriquant de la cavité laser 1 et se situe en général entre 100 à 1000 $\mu$m. A titre d'exemple, on peut prendre une diode laser de longueur d'onde d'émission $\lambda$, = 980 nm, de largeur de ruban 100 $\mu$m, de longueur $L_c$ = 1000 $\mu$m et d'indice de réfraction $n_c$ =3,3.

La longueur $L_1$ peut-être plus ou moins importante. Dans certains cas, le miroir concave peut même être disposé directement en entrée de l'élément optique, ce qui réduit la longueur de la zone d'entrée à la flèche h du miroir concave. Cette longueur $L_1$ doit être telle que $L_1+L_2$ permettent un bon couplage dans le microguide. $L_1+L_2$ sera en général supérieur à 10 000 $\mu$m.

Si on prend L = 20 000 $\mu$m, on prendra $L_1$ par exemple égal à 10 000 $\mu$m pour un substrat de verre dont l'indice effectif du guide est $n_1$=1,51 et une distance D égal à par exemple à 10 $\mu$m, lorsque la zone en espace libre est de l'air d'indice de réfraction 1.

Les dimensions du miroir concave 7, sont déterminées de façon que le diamètre $2.w_0$ du faisceau optique 5 sur le miroir plan $R_1$ ($w_0$ étant le rayon dudit faisceau) soit supérieur à la largeur du ruban de la cavité 1. A titre d'exemple pour un ruban de 100 $\mu$m, on a $w_0 > 50$ $\mu$m : on choisira par exemple $w_0 = 60$ $\mu$m.

La valeur $w_0$ est liée à R et L par la relation : $w_0^2 = \lambda / \pi [L. (R-L)]^{1/2}$ où $\lambda$ est la longueur d'onde considérée du faisceau lumineux.

De cette relation et de l'inégalité R > L, on en déduit R supérieur ou égal à 50 000 $\mu$m.

A titre d'exemple, on prendra R compris entre 50 000 à 60 000 $\mu$m et L = 20 000 $\mu$m.

Par ailleurs, pour déterminer le diamètre d du miroir 7, on détermine la dimension 2w du faisceau lumineux sur ledit miroir à partir de la relation :

$$w^2 = \frac{\lambda R}{\pi} [L \ / \ (R-L)]^{1/2}$$

où $\lambda$ est la longueur d'onde considérée du faisceau lumineux.

Avec les valeurs de R et L données ci-dessus, on obtient w supérieur environ à 80 $\mu$m (voire 100 $\mu$m)

Le diamètre d du miroir doit être supérieur à 2w. On prendra donc par exemple d supérieur ou égal à 200 $\mu$m.

Enfin, pour que la flèche h du miroir soit réalisable, on choisira par exemple, h > 1 $\mu$m. La flèche du miroir est liée au diamètre d et au rayon de courbure R de ce dernier par la relation suivante : $h / R = 1-(1-d^2/4R^2)^{1/2}$. A partir de l'approximation $h / R = d^2/8R$, on prendra par exemple d = 600 à 800 $\mu$m pour R supérieur ou égal à 50 000 $\mu$m et h environ 1 $\mu$m.

La figure 2 est une variante dans le plan xz du premier mode de réalisation présentant, dans l'espace libre situé entre la cavité laser 1 et l'élément d'optique guidé 3, des moyens de focalisation 15.

Ces moyens de focalisation sont réalisés par exemple par des moyens de collimation, ils permettent d'optimiser le couplage entre la cavité laser et l'entrée de l'élément 3, au moins dans le plan xz perpendiculaire au plan de guidage.

En effet, le faisceau 5 issu de la cavité laser est en général fortement divergent suivant l'axe x et plus faiblement divergent suivant l'axe y. Il est donc particulièrement avantageux de focaliser le faisceau dans le plan xz.

Ces moyens de focalisation sont réalisés par exemple par une lentille de type cylindrique, sphérique, par une micro-lentille ou encore par une fibre à gradient d'indice. Un traitement anti-reflet des moyens de focalisation peut-être réalisé pour éviter de former des cavités optiques parasites avec la cavité laser.

La figure 3 représente schématiquement en coupe un deuxième mode de réalisation de la source de l'invention.

Dans ce mode, la cavité laser est disposée directement sur une des parois parallèles au plan xy de l'élément d'optique guidée au niveau de la zone $G_1$ de guidage d'entrée. Un tel assemblage peut être obtenu par toutes les techniques d'assemblage classiques.

Dans ce mode de réalisation, il n'existe pas d'espace libre entre la cavité et la zone de guidage d'entrée. La longueur L correspond alors à $n_c.L_c + n_1.L_1$ et est égal par exemple également à 20 000 $\mu$m.

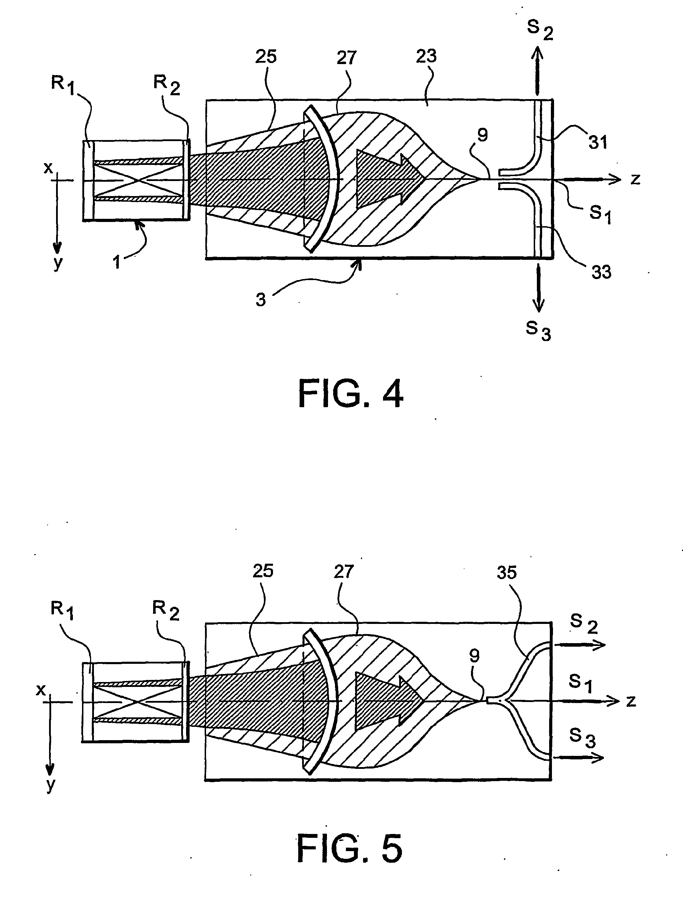

La figure 4 représente schématiquement en coupe une source laser selon l'invention à plusieurs sorties optiques.

Pour cela, la zone $G_3$ comporte deux coupleurs 31, 33 disposés respectivement de part et d'autre du microguide 9 de sorte que la source comporte trois sorties : la sortie $S_1$ du microguide 9, la sortie $S_2$ du coupleur 31 et la sortie $S_3$ du coupleur 33. Les coupleurs 31, 33 sont réalisés par des microguides dans le substrat 23.

Sur la figure 4, à titre d'exemple, la sortie $S_1$ est située sur une paroi de l'élément 3, parallèle au plan xy tandis que les sorties $S_2$ et $S_3$ se situent sur des parois distinctes entre elles et parallèles au plan xz. Bien entendu les sorties $S_1$, $S_2$, $S_3$ peuvent être disposées différemment et en particulier être toutes sur une des parois du substrat.

La figure 5 représente schématiquement une variante de la figure 4 dans laquelle pour avoir trois sorties $S_1$, $S_2$ et $S_3$, la zone $G_3$ comporte un diviseur 35 de 1 vers 3 relié au microguide 9. A titre d'exemple, sur cette figure les trois sorties $S_1$, $S_2$, $S_3$ se situent sur une même paroi parallèle au plan yx de l'élément. Bien entendu, d'autres configurations peuvent être réalisées.

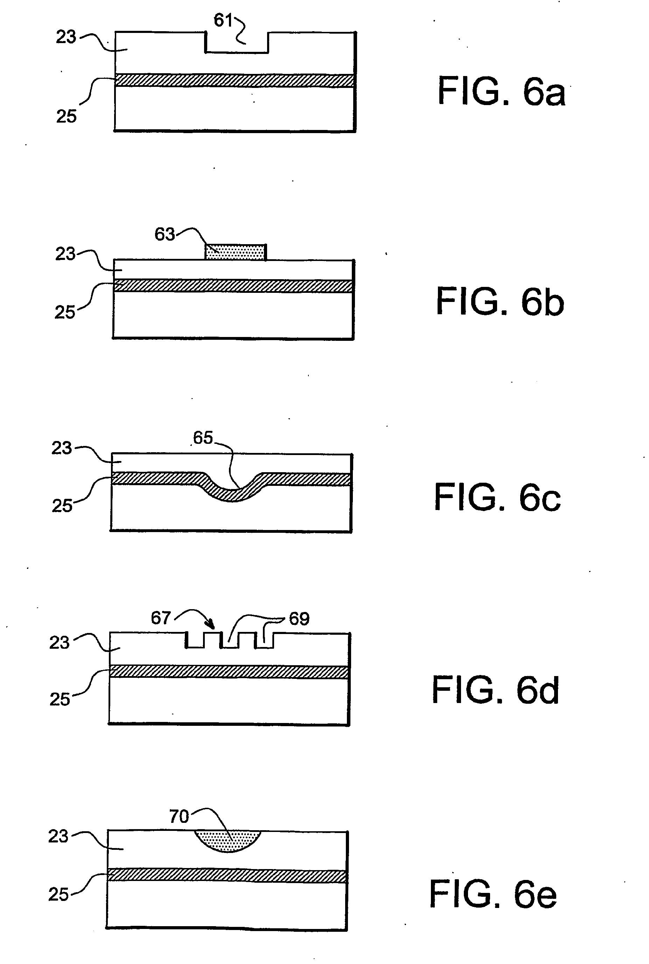

Il existe de nombreuses façons d'obtenir le miroir concave de l'invention par une variation de l'indice effectif du guide 25. Les figures 6a à 6e illustrent en coupe selon un plan xz, cinq exemples de miroirs concaves utilisables dans l'invention.

Dans la figure 6a, cette variation d'indice est obtenue par une gravure 61 localisée du substrat 23 au-dessus du guide planaire 25 de la zone d'entrée. Cette gravure permet d'obtenir une cavité concave remplie par le milieu ambiant en général de l'air. Cette cavité présente dans le plan yz non représenté sur cette figure un rayon de courbure R et un diamètre d tels que définis précédemment. A titre d'exemple, cette cavité présente une profondeur de quelques 100 nm et une largeur dans le plan xz de quelques $\mu$m.

Le miroir 7 est donc formé par cette cavité 61 et la partie du guide 25 dans laquelle la cavité induit cette variation d'indice.

Dans la figure 6b, cette variation d'indice est obtenue par un dépôt local d'au moins une couche 63 sur le substrat au-dessus du guide planaire 25. Ce dépôt présente dans le plan yz (non représenté) un rayon de courbure R et un diamètre d tels que définis précédemment.

Pour un substrat en verre, le dépôt 63 est par exemple de la silice, un métal ou encore un polymère de quelques 100 nm à quelques 10 $\mu$m d'épaisseur et une largeur dans le plan xz de quelques $\mu$m.

Le miroir 7 est donc formé par cette couche 63 et la partie du guide 25 dans laquelle la couche induit cette variation d'indice.

Dans la figure 6c, cette variation d'indice est obtenue par un enterrage 65 local du guide planaire 25 dans le substrat. Cet enterrage 65 présente dans le plan yz (non représenté) un rayon de courbure R et un diamètre d tels que définis précédemment.

Cet enterrage est obtenu par exemple dans le cas d'un substrat de verre avec un guide réalisé par la technique d'échanges d'ions par une diffusion localisée à travers un masque, par exemple d'aluminium.

Le miroir 7 est donc formé par la partie du guide 25 dans laquelle l'enterrage local induit cette variation d'indice.

Dans la figure 6d, cette variation d'indice est obtenue par un réseau de Bragg 67 dans le substrat au-dessus du guide planaire 25. Ce réseau peut comporter quelques périodes à quelques centaines de périodes. Sur cette figure, le réseau 67 comporte trois périodes comportant des gravures 69 formés dans le substrat. Ce réseau comme décrit ci-dessus présente dans le plan yz (non représenté) un rayon de courbure R et un diamètre d tels que définis précédemment. Ce réseau est gravé dans le substrat, soit par des techniques classiques de photolithographie et de gravure, soit par une photo-inscription directe lorsque le substrat est photosensible.

A titre d'exemple, la période du réseau $p = \lambda / 2.n_1$, aussi pour un guide d'indice $n_1 = 1,5$ et $\lambda = 980$ nm, on obtient p = 325 nm. La profondeur des gravures est par exemple de quelques 10 à quelques 100 nm et la largeur dans le plan xz de ces gravures est par exemple de p/2.

Le miroir 7 est donc formé par ce réseau 67 et la partie du guide 25 dans laquelle le réseau induit cette variation d'indice.

Enfin, la figure 6e représente un miroir 7 obtenu par un échange d'ions localisé dans le substrat. Ainsi, après réalisation du guide 25 dans le substrat, par exemple par une étape préalable d'échange d'ions, l'échange d'ions localisé est obtenu par l'utilisation d'un bain contenant par exemple des ions $Ag^+$ pour un substrat en verre contenant des ions $Na^+$ et d'un masque approprié de façon que l'échange d'ions soit réalisé dans une zone 70 du substrat sur une largeur dans le plan de la figure de quelques $\mu$m et avec les paramètres R et d tels que définis précédemment.

Le miroir 7 est donc formé par cette zone 70 et la partie du guide 25 dans laquelle ladite zone induit cette variation d'indice.

Comme on l'a vu précédemment, la source laser de l'invention permet de fournir sur une ou plusieurs sorties des faisceaux lumineux monomodes ou peu multimodes et peut présenter une forte puissance. De ce fait, la source de l'invention s'applique dans de nombreux domaines et notamment comme pompe pour des amplificateurs optiques ou pour des lasers à fibres ou solides ou encore comme source laser d'usinage et/ou marquage de matériaux.

**Revendications**

1. Source laser à cavité laser étendue, comportant :

   - une cavité laser (1) apte à émettre un faisceau optique (5),
   - un élément d'optique guidée (3) présentant dans un substrat:

     • une zone ($G_1$) de guidage d'entrée,
     • une zone ($G_3$) de sortie comprenant au moins un microguide (9) associé à au moins une sortie ($S_1$) optique de la source, et
     • une zone ($G_2$) de guidage planaire d'adaptation entre la zone d'entrée et le microguide, la zone de guidage d'entrée étant apte à recevoir le faisceau optique émis par la cavité et à le transmettre à la zone de guidage d'adaptation qui est apte à le guider vers le microguide,
     **caractérisée en ce que** la zone de guidage d'entrée comporte un miroir concave au moins dans un plan de guidage de la zone d'entrée, de façon à réaliser avec la cavité laser une cavité laser étendue.

2. Source laser selon la revendication 1, **caractérisée en ce que** la cavité laser est une diode laser comportant au moins un miroir plan ($R_1$).

3. Source laser selon la revendication 1, **caractérisée en ce que** la cavité laser (1) est disposée directement sur l'élément (3) d'optique guidée au niveau de la zone ($G_1$) de guidage d'entrée de cet élément.

4. Source laser selon la revendication 1, **caractérisée en ce que** la cavité laser (1) est séparée de la zone d'entrée de l'élément (3) d'optique guidée par une zone d'espace libre.

5. Source laser selon la revendication 4, **caractérisée en ce que** la source comporte en outre des moyens de focalisation situés entre la cavité (1) et la zone d'entrée de l'élément (3) d'optique guidée, ces moyens étant aptes à focaliser le faisceau optique émis par la cavité laser dans la zone de guidage d'entrée, au moins, dans un plan perpendiculaire au plan de guidage de ladite zone.

6. Source laser selon la revendication 1, **caractérisée en ce que** l'élément d'optique guidée (3) est réalisé à partir d'un substrat en verre.

7. Source laser selon la revendication 1, **caractérisée en ce que** la zone de guidage d'entrée comporte un guide planaire (25) reliée à la zone de guidage d'adaptation ($G_2$) par le miroir concave (7).

8. Source laser selon la revendication 7, **caractérisée en ce que** le miroir concave (7) est réalisé par une variation locale d'indice effectif du guide planaire de la zone de guidage d'entrée.

9. Source laser selon la revendication 8, **caractérisée en ce que** ladite variation d'indice effectif est réalisée par une cavité dans le substrat, au-dessus du guide planaire, ou par un dépôt local d'au moins une couche sur le substrat, au-dessus du guide planaire, ou par un enterrage local du guide planaire, ou par un échange d'ions localisé dans le substrat au-dessus du guide planaire, ou encore par un réseau de Bragg dans le substrat au-dessus du guide planaire

10. Source laser selon la revendication 1, **caractérisée en ce que** le miroir concave est apte à filtrer en longueurs d'onde le faisceau optique.

11. Source laser selon la revendication 1, **caractérisée en ce que** la zone de guidage d'adaptation comprend un guide planaire (27) en forme d'entonnoir.

12. Source laser selon la revendication 11, **caractérisée en ce que** le guide planaire en forme d'entonnoir de la zone de guidage d'adaptation est adiabatique.

**13.** Source laser selon la revendication 1, **caractérisée en ce qu'**elle comporte en outre au moins un diviseur (35) à une entrée et à n sorties, dans la zone($G_3$) de sortie de l'élément, ledit diviseur étant relié en entrée au microguide (9) de sorte que les n sorties du diviseur forment n sorties de la source.

**14.** Source laser selon la revendication 1, **caractérisée en ce qu'**elle comporte en outre x coupleurs dans la zone ($G_3$) de sortie de l'élément, chaque coupleur (31, 33) étant associé au microguide de sorte que respectivement le microguide et chacun des coupleurs forment une sortie ($S_1$, $S_2$, $S_3$) de la source.

**15.** Source laser selon la revendication 1, **caractérisée en ce que** le miroir concave présente un rayon de courbure R supérieur ou égal à une longueur optique de la source définie par $L = n_c.L_c + n_e.D + n_1.L_1$ où $n_1$ est l'indice effectif de la zone de guidage d'entrée et $n_c$, $n_e$ sont les indices de réfraction respectivement du matériau de la cavité laser et du milieu de la zone d'espace libre intercalé entre la cavité et l'élément d'optique guidé et $L_c$, D, $L_1$ sont respectivement les longueurs de la cavité, de la zone d'espace libre située entre la cavité et l'élément d'optique guidé, et de la zone d'entrée.

**16.** Source laser selon la revendication 15, **caractérisée en ce que** les caractéristiques géométriques du miroir concave (7) sont définis dans le cas de l'utilisation d'une cavité laser à ruban, par les égalités et inégalités suivantes :

$$W_o{}^2 = \frac{\lambda}{\pi} [L.(R-L)]^{\frac{1}{2}} \text{ et } 2w_0 > l_r$$

$$w^2 = \frac{\lambda R}{\pi} [L / (R-L)]^{\frac{1}{2}}$$

$$R > L$$

$$L = n_c.L_c + n_e.D + n_1.L_1$$

$$H / R = 1 - (1 - d^2/4R^2)^{\frac{1}{2}}$$

$$d > 2w$$

où $\lambda$ est la longueur d'onde considérée du faisceau lumineux, $w_0$ est le rayon dudit faisceau sur un miroir plan de la cavité, $l_r$ est la largeur du ruban de la cavité laser, R le rayon de courbure du miroir concave, L la longueur optique de la source, w le rayon du faisceau lumineux sur le miroir concave, h la flèche dudit miroir concave dans le plan de guidage, d le diamètre de ce miroir.

**Claims**

1. Laser source with an extended laser cavity, comprising:

   - a laser cavity (1) capable of emitting an optical beam (5),
   - a guided optical element (3) with the following areas in a substrate:

     • an input guide area ($G_1$),
     • an output area ($G_3$) comprising at least one microguide (9) associated with at least one optical output ($S_1$) from the source, and
     • a planar adaptor guide area ($G_2$) between the input area and the microguides, the input guide area being capable of receiving the optical beam emitted by the cavity and transmitting it to the adaptor guide area, the adaptor guide area being capable of guiding it to the microguide,

   **characterized in that** the input guide area comprises a mirror that is concave in at least one guide plane of the input area, so as to make an extended laser cavity with the laser cavity.

2. Laser source according to claim 1, **characterised in that** the laser cavity is a laser diode comprising at least a plane mirror ($R_1$).

3. Laser source according to claim 1, **characterised in that** the laser cavity (1) is arranged directly on the guided optical element (3) at the input guide area ($G_1$) to this element.

4. Laser source according to claim 1, **characterised in that** the laser cavity (1) is separated from the input area of the guided optical element (3) by a free space area.

5. Laser source according to claim 4, **characterised in that** the source also comprises focusing means located between the cavity (1) and the input area of the guided optical element (3), these means being capable of focusing the optical beam emitted by the laser cavity in the input guide area, in at least a perpendicular plane to the guide plane of said area.

6. Laser source according to claim 1, **characterised in that** the guided optical element (3) is made from a glass substrate.

7. Laser source according to claim 1, **characterised in that** the input guide area comprises a planar guide (25) connected to the adaptor guide area ($G_2$) through the concave mirror (7).

8. Laser source according to claim 7, **characterised in that** the concave mirror (7) is made by a local variation of the effective index of the planar guide of the input guide area.

9. Laser source according to claim 8, **characterised in that** said variation of the effective index is obtained by a cavity located in the substrate above the planar guide, or by a local deposition of at least one layer on the substrate above the planar guide, or by local burying of the planar guide, or by an ion exchange located in the substrate above the planar guide or by a Bragg grating in the substrate above the planar guide.

10. Laser source according to claim 1, **characterised in that** the concave mirror is capable of filtering the optical beam in wavelengths.

11. Laser source according to claim 1, **characterised in that** the adaptor guide area comprises a planar guide (27) in the form of a taper.

12. Laser source according to claim 11, **characterised in that** the planar taper shaped guide in the adaptor guide area is adiabatic.

13. Laser source according to claim 1, **characterised in that** it also comprises at least one divider (35) with one input and n outputs, in the output area (G$_3$) from the element, the input of said divider being connected to the microguide (9) such that the n outputs from the divider act as n outputs from the source.

14. Laser source according to claim 1, **characterised in that** it also comprises x couplers in the element output area (G$_3$), each coupler (31, 33) being associated with the microguide such that the microguide and each of the couplers form an output (S$_1$, S$_2$, S$_3$) respectively from the source.

15. Laser source according to claim 1, **characterised in that** the concave mirror has a radius of curvature R greater than or equal to the optical length L of the source defined by the relation $L = n_c.L_c + n_e.D + n_1.L_1$ where $n_1$ is the effective index of the input guide area and $n_c$, $n_e$ are the refraction indexes of the material in the laser cavity and the medium in the free area between the cavity and the guided optical element, and $L_c$, D and $L_1$ are the cavity length, the length of the free space area between the cavity and the guided optical element, and the length of the input area, respectively.

16. Laser source according to claim 15, **characterised in that** the geometric characteristics of the concave mirror (7) are defined using the following qualities and inequalities for the case in which a ribbon laser cavity is used:

-

$$W_0{}^2 = \frac{\lambda}{\pi} \ [L.(R-L)]^{1/2} \ \text{and} \ 2w_0 > l_r$$

-

$$w^2 = \frac{\lambda R}{\pi} \ [L \ / \ (R-L)]^{1/2}$$

-

$$R > L$$

-

$$L = n_c. \ L_c + n_e. \ D + n_1.L_1$$

-

$$H \ / \ R = 1-(1-d^2/4R^2)^{1/2}$$

-

$$d > 2w$$

where $\lambda$ is the wavelength considered of the light beam, $w_0$ is the radius of the said beam on a plane mirror of the cavity, $l_r$ is the width of the ribbon of the laser cavity, R is the radius of curvature of the concave mirror, L is the optical length of the source, w is the radius of the light beam on the concave mirror, h is the bow of said concave mirror in the guide plane and d is the diameter of this mirror.

**Patentansprüche**

1. Laserquelle mit ausgedehntem Laserresonator, umfassend:

   - einen Laserresonator (1), der dazu ausgelegt ist, einen optischen Strahl (5) zu emittieren,
   - ein Lichtleiterelement (3), weiche in einem Substrat folgendes aufweiset:

     • eine Eingangsleiterzone ($G_1$),
     • eine Ausgangszone ($G_3$), die wenigstens einen Mikroleiter (9) umfasst, der wenigstens einem optischen Ausgang ($S_1$) der Quelle zugeordnet ist, und
     • eine planare Anpassungsleiterzone ($G_2$) zwischen der Eingangszone und dem Mikroleiter, wobei die Eingangsleiterzone dazu ausgelegt ist, den vom Resonator emittierten optischen Strahl zu empfangen und ihn zur Anpassungsleiterzone zu transmittierten, die dazu ausgelegt ist, ihn zum Mikroleiter hin zu leiten,

   **dadurch** gekennzeichnet, dass die Eingangsleiterzone einen Spiegel umfasst, der wenigstens in einer Leiterebene der Eingangszone konkav ist, derart, dass mit dem Laserresonator ein ausgedehnter Laserresonator realisiert wird.

2. Laserquelle nach Anspruch 1, **dadurch** gekennzeichnet, dass der Laserresonator eine Laserdiode ist, die wenigstens einen Planspiegel ($R_1$) umfasst.

3. Laserquelle nach Anspruch 1, **dadurch gekennzeichnet, dass** der Laserresonator (1) direkt auf dem Lichtleiterelement (3) im Bereich der Eingangsleiterzone ($G_1$) dieses Elements angeordnet ist.

4. Laserquelle nach Anspruch 1, **dadurch** gekennzeichnet, dass der Laserresonator (1) von der Eingangszone des Lichtleiterelements (3) durch eine Freiraumzone getrennt ist.

5. Laserquelle nach Anspruch 4, **dadurch gekennzeichnet, dass** die Quelle ferner Fokussiermittel umfasst, die zwischen dem Resonator (1) und der Eingangszone des Lichtleiterelements (3) angeordnet sind, wobei diese Mittel dazu ausgelegt sind, den vom Laserresonator emittierten optischen Strahl in die Eingangsleiterzone wenigstens in einer Ebene zu fokussieren, die orthogonal ist zur Leiterebene der Zone.

6. Laserquelle nach Anspruch 1, **dadurch gekennzeichnet, dass** das Lichtleiterelement (3) ausgehend von einem Glassubstrat hergestellt ist.

7. Laserquelle nach Anspruch 1, **dadurch gekennzeichnet, dass** die Eingangsleiterzone einen planaren Leiter (25) umfasst, der mittels des konkaven Spiegels (7) mit der Anpassungsleiterzone ($G_2$) verbunden ist.

8. Laserquelle nach Anspruch 7, **dadurch gekennzeichnet, dass** der konkave Spiegel (7) durch eine lokale Variation des effektiven Index des planaren Leiters der Eingangsleiterzone realisiert ist.

9. Laserquelle nach Anspruch 8, **dadurch gekennzeichnet, dass** die Variation des effektiven Index durch einen Hohlraum in dem Substrat über dem planaren Leiter realisiert ist, oder durch eine lokale Abscheidung wenigstens einer Schicht auf dem Substrat über dem planaren Leiter oder durch ein lokales Eingraben des planaren Leiters, oder durch einen lokalisierten Ionenaustausch in dem Substrat über dem planaren Leiter, oder auch durch ein Bragg-Gitter in dem Substrat über dem planaren Leiter.

10. Laserquelle nach Anspruch 1, **dadurch gekennzeichnet, dass** der konkave Spiegel dazu ausgelegt ist, den optischen Strahl nach Wellenlängen zu filtern

11. Laserquelle nach Anspruch 1, **dadurch gekennzeichnet, dass** die Anpassungsleiterzone einen trichterförmigen planaren Leiter (27) umfasst.

12. Laserquelle nach Anspruch 19 , **dadurch gekennzeichnet, dass** der trichterförmige planare Leiter der Anpassungsleiterzone adiabatisch ist.

13. Laserquelle nach Anspruch 1, **dadurch gekennzeichnet, dass** sie ferner wenigstens einen Teiler (35) mit einem Eingang und mit n Ausgängen in der Ausgangszone ($G_3$) des Elementes umfasst, wobei der Teiler am Eingang mit dem Mikroleiter (9) derart verbunden ist, dass die n Ausgänge des Teilers n Ausgänge der Quelle bilden.

14. Laserquelle nach Anspruch 1, **dadurch gekennzeichnet, dass** sie ferner x Koppler in der Ausgangszone ($G_3$) des Elements umfasst, wobei jeder Koppler (31, 33) dem Mikraleiter derart zugeordnet ist, dass jeweils der Mikroleiter und jeder der Koppler einen Ausgang ($S_1$, $S_2$, $S_3$) der Quelle bilden,

15. Laserquelle nach Anspruch 1, **dadurch gekennzeichnet, dass** der konkave Spiegel einen Krümmungsradius R aufweist, der größer oder gleich einer optischen Länge der Quelle ist, definiert durch $L = n_c \cdot L_c + n_e \cdot D + n_l \cdot L_l$, wobei $n_1$ der effektive Index der Eingangsleiterzone ist und wobei $n_c$, $n_e$ die Brechungsindices des Materials des Laserresonators bzw. der Umgebung der Freiraumzone sind, die sich zwischen dem Resonator und dem Lichtleiterelement befindet, und wobei $L_c$, D, $L_1$ die Längen des Resonators, der zwischen dem Resonator und dem Lichtleiterelement befindlichen Freiraumzone beziehungsweise der Eingangszone sind.

16. Laserquelle nach Anspruch 15, **dadurch gekennzeichnet, dass** die geometrischen Eigenschaften des konkaven Spiegels (7) im Fall der Verwendung eines Band-Laserresonators durch die folgenden Gleichungen und Ungleichungen definiert sind:

-

$$W_0^2 = \frac{\lambda}{\pi}\left[L \cdot (R - L)\right]^{\frac{1}{2}} \text{ und } 2w_0 > l_r$$

-

$$w^2 = \frac{\lambda R}{\pi}\left[L / (R - L)\right]^{\frac{1}{2}}$$

-

$$R > L$$

-

$$L = n_c \cdot L_c + n_e \cdot D + n_l \cdot L_l$$

-

$$H / R = 1 - \left(1 - d^2 / 4R^2\right)^{\frac{1}{2}}$$

-

$$d > 2w ,$$

wobei $\lambda$ die betrachtete Wellenlänge des Lichtstrahls ist, $w_0$ der Radius des Strahls auf einem Planspiegel des

Resonators ist, $l_r$ die Breite des Bandes des Laserresonators ist, R der Krümmungsradius des konkaven Spiegels ist, L die optische Länge der Quelle ist, w der Radius des Lichtsstrahls auf dem konkaven Spiegel ist, h die Durchbiegung des konkaven Spiegels in der Leiterebene ist und d der Durchmesser dieses Spiegels ist.

EP 1 433 232 B1

FIG. 1

FIG. 2

FIG. 3

FIG. 4

FIG. 5

FIG. 6a

FIG. 6b

FIG. 6c

FIG. 6d

FIG. 6e

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5513196 A
- JP 01231387 A
- US 4677630 A

**Littérature non-brevet citée dans la description**

- *PATENT ABSTRACTS OF JAPAN,* 12 Décembre 1989, vol. 013, 558 (E-858)
- **P. Modh et al.** Deep-etched distributed Bragg reflector lasers with curved mirrors. Experiments and modeling. *IEEE Journal of Quantum Electronics,* Juin 2001, vol. 37 (6?